# EUROPÄISCHE PATENTSCHRIFT

(11) **EP 1 149 184 B1**
(45) Veröffentlichungstag und Bekanntmachung des Hinweises auf die Patenterteilung: **09.08.2006**
(21) Anmeldenummer: 99963277.1
(22) Anmeldetag: 02.12.1999
(51) Int. Cl.: C23C 16/46, C30B 25/02, C23C 16/30, C30B 29/40, C30B 25/10, C23C 16/52

(54) **VERFAHREN UND SYSTEM ZUR HALBLEITERKRISTALLHERSTELLUNG MIT TEMPERATURVERWALTUNG**
METHOD AND SYSTEM FOR PRODUCING SEMICONDUCTOR CRYSTALS USING TEMPERATURE MANAGEMENT
PROCEDE ET SYSTEME DE FABRICATION D'UN CRISTAL SEMI-CONDUCTEUR AVEC GESTION DE LA TEMPERATURE

(30) Priorität: 02.12.1998 DE 19855637
(43) Veröffentlichungstag der Anmeldung: 31.10.2001
(73) Patentinhaber: AIXTRON Aktiengesellschaft, 52072 Aachen (DE)
(72) Erfinder: HEUKEN, Michael, D-52078 Aachen (DE); STRAUCH, Gert, D-52072 Aachen (DE); PROTZMANN, Harry, D-52064 Aachen (DE); JÜRGENSEN, Holger, D-52072 Aachen (DE); SCHÖN, Oliver, D-52134 Herzogenrath (DE); SCHMITZ, Dietmar, D-52072 Aachen (DE)
(74) Vertreter: Grundmann, Dirk
(86) Internationale Anmeldenummer: PCT/DE1999/003863
(87) Internationale Veröffentlichungsnummer: WO 2000/032840

(56) Entgegenhaltungen:
- WO-A-97/08356
- SCHMITZ D ET AL: "MOVPE GROWTH OF INGAN ON SAPPHIRE USING GROWTH INITIATION CYCLES" MATERIALS SCIENCE AND ENGINEERING B,CH,ELSEVIER SEQUOIA, LAUSANNE, Bd. B43, Nr. 1/03, 1. Januar 1997 (1997-01-01), Seiten 228-236, XP000722623 ISSN: 0921-5107
- JURGENSEN H ET AL: "MOCVD equipment for recent developments towards the blue and green solid state laser" MRS INTERNET JOURNAL OF NITRIDE SEMICONDUCTOR RESEARCH, 1996, MATER. RES. SOC, UK, Bd. 1, XP000905535 ISSN: 1092-5783
- BECCARD R ET AL: "Multiwafer MOVPE technology for low dimensional Ga-Al-In-N structures" MATERIALS SCIENCE AND ENGINEERING B,CH,ELSEVIER SEQUOIA, LAUSANNE, Bd. 51, Nr. 1-3, 27. Februar 1998 (1998-02-27), Seiten 39-43, XP004129531 ISSN: 0921-5107

## Beschreibung

### Technisches Gebiet

Die Erfindung bezieht sich auf ein Verfahren zur Herstellung von Stickstoff enthaltenden Halbleiterkristallmaterialien der Form A_{X}B_{Y}C_{Z}N_{V}M_{W}, wobei A, B, C Gruppe-II- oder III-Elemente, N Stickstoff, M ein Gruppe-V- oder VI-Element und X, Y, Z, V, W der Molenbruch jedes Elements in dieser Verbindung darstellen, unter Verwendung eines Temperaturverwaltungssystems.

### Stand der Technik

Binäre, temäre und quaternäre Verbindungshalbleiter wie beispielsweise GaAs, InP, AlₓGa₁₋ₓAs, InₓGa₁₋ₓAs, (AlₓGa₁₋ₓ)_{y} In_{1-y}P und InₓGa_{y}As₁₋ₓP_{1-y} werden derzeit in mehreren elektronischen und optoelektronischen Vorrichtungen verwendet. Die komplizierten Schichtfolgen können aus der Gasphase hergestellt werden, die die in das Gitter einzugliedernden Elemente trägt. Zusammensetzung, Dotierung und Schichtfolge werden gewöhnlich durch die Gasphasenzusammensetzung wie auch durch die Schaltfolge der Gasphase unter Verwendung einer konstanten Temperatur bestimmt. Dies entspricht dem heutigen Stand der Technik zur Herstellung von qualitativ hochwertigem Material für Bauelemente. Stickstoff enthaltende Halbleiter wie beispielsweise GaN, InGaN, AlGaN, GaAsN, daß heißt Halbleiter der Form A_{X}B_{Y}C_{Z}N_{V}M_{W} (A, B, C stellen Gruppe-II- oder III-Elemente dar, N ist Stickstoff, M ist ein Gruppe-V- oder VI-Element und X, Y, Z, V, W ist der Molenbruch jedes Elements in dieser Verbindung) können auf eine unterschiedliche Weise hergestellt werden. Erfindungsgemäß wird zur Herstellung von (nachstehend mit Stickstoff enthaltenden Halbleitermaterialien bezeichneten) A_{X}B_{Y}C_{Z}N_{V}M_{W}-Materialien ein Temperaturverwaltungssystem verwendet.

Gemäß dem Stand der Technik werden bei der Herstellung die Eigenschaften der Stickstoff enthaltenden Halbleitermaterialien durch die Zusammensetzung der Gasphase als auch der Schaltfolge der Gasphasen bestimmt. Temperaturen werden dabei konstant gehalten. Da zur Festlegung der Eigenschaften der Stickstoff enthaltenden Halbleitermaterialien nur zwei Parameter verwendet werden, ist diese Art der Eigenschaftsfestlegung als eher undifferenziert zu bezeichnen. Damit ist gemeint, daß eine Festlegung der Zusammensetzung, Dotierung und Schichtfolge zwar möglich ist, daß jedoch bei Berücksichtigung weiterer gewünschter, nachstehend beschriebener Eigenschaften eine optimale Abstimmung sehr schwierig ist, was einen komplizierten Herstellungsprozeß mit vielen Verfahrensschritten zu Folge hat. Somit verlängert sich die Herstellungsdauer und die Herstellungskosten sind hoch. Ein derartiges Verfahren beschreibt die Veröffentlichung "MOVPE growth of InGaN on sapphire using growth initiation cycles", Materials Science and Engineering B43 (1997) 228,236.

### Darstellung der Erfindung

Es ist Aufgabe der Erfindung ein Verfahren zur Herstellung von Stickstoff enthaltenden Halbleiterkristallmaterialien der Form A_{X}B_{Y}C_{Z},N_{V},M_{W} bereitzustellen, wobei A, B, C Gruppe-II- oder III- Elemente, N Stickstoff, M ein Gruppe-V- oder VI-Element und X, Y, Z, V, W der Molenbruch jedes Elements in dieser Verbindung darstellen, die eine differenziertere Eigenschaftsfestlegung ermöglichen. Das heißt neben einer Festlegung der Zusammensetzung, Dotierung und Schichtfolge soll noch bei Berücksichtigung weiterer gewünschter, nachstehend beschriebener Eigenschaften eine optimale Abstimmung ermöglicht werden. Dabei sollen komplizierte Herstellungsprozesse mit vielen Verfahrensschritten vermieden werden. Als Folge verringern sich Herstellungsdauer und Herstellungskosten.

Die der Erfindung zugrundegelegte Aufgabe wird durch ein Verfahren nach dem Hauptanspruch gelöst. Weiterbildungen des erfindungsgemäßen Verfahrens sind Gegenstand der Unteransprüche.

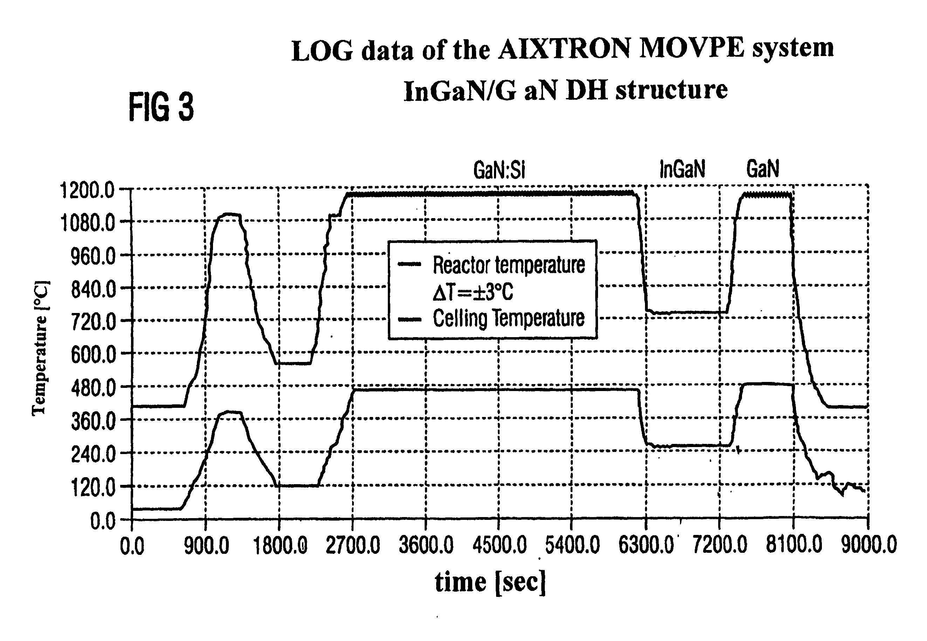

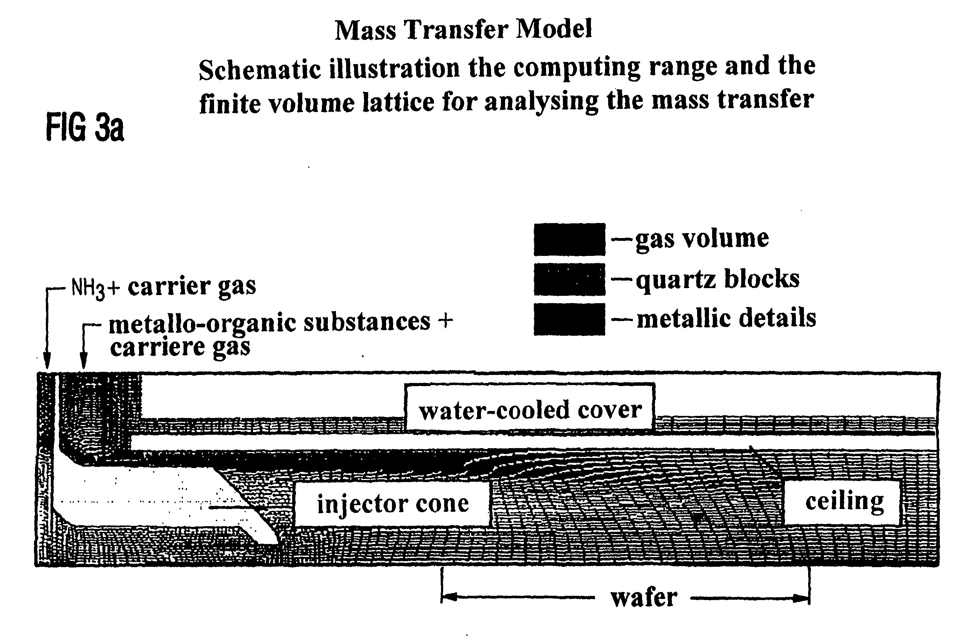

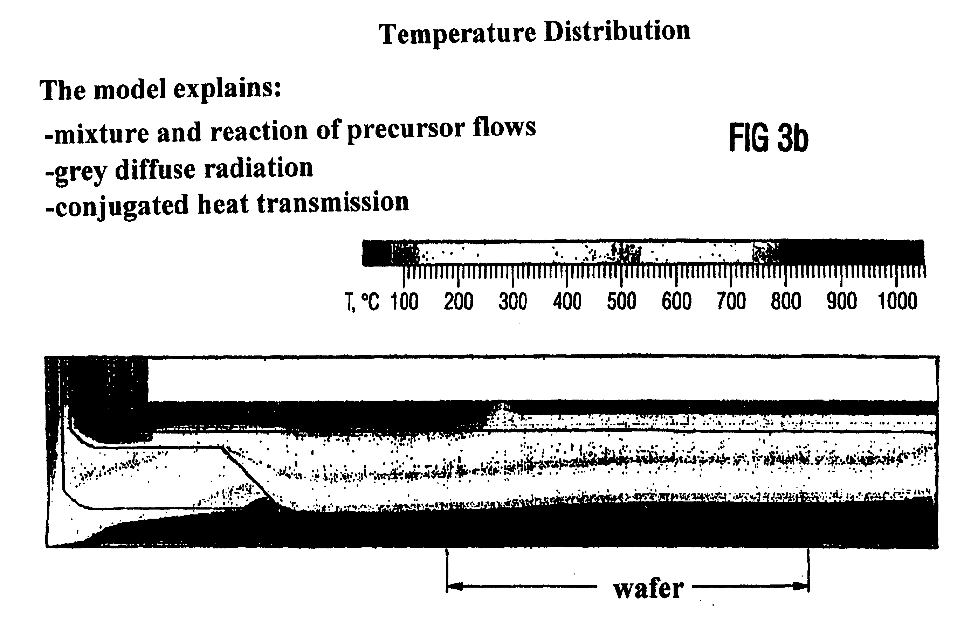

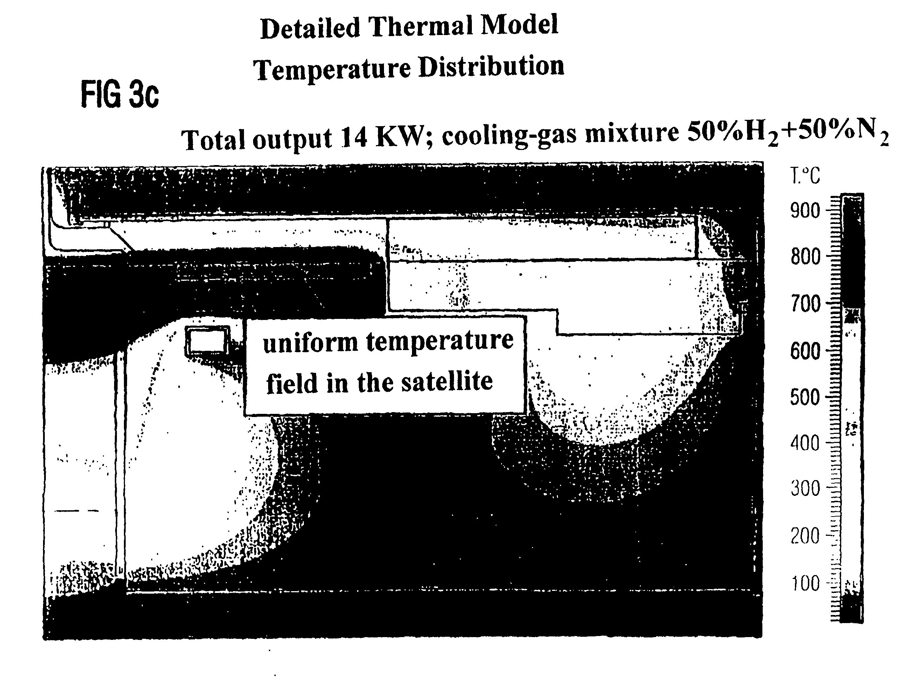

Erfindungsgemäß wird das dynamische Verhalten aller Temperaturen beherrscht. Temperaturänderungen erfolgen insbesondere im Bereich von Sekunden. Da gleichzeitig andere Eigenschaften im Reaktor geändert werden können, z. B. Austausch des Trägergases Wasserstoff zu Stickstoff und damit geänderte Wärmeleitfähigkeit, sind die Korrelationen der Temperaturen z. B. zwischen Reaktionskammeroberseite T₇ und RF-Spule T₈ ebenfalls zeitlich variabel (siehe auch Fig. 3) und zu beherrschen.

Erfindungsgemäß werden die Tempaturen, die Temperaturdynamik, Temperaturbereiche und die Korrelation aller Temperaturen sowie die sich ändernden Prozeßparameter im Reaktor von der erfindungsgemäßen Temperatunrerwaltung berücksichtigt.

Erfindungsgemäß sind der Temperaturverwaltung insbesondere Temperaturprofile zugrunde gelegt, die anhand von numerischen Simulationen ermittelt wurden.

Bei den genannten Halbleiterkristallmaterialverbindungen werden insbesondere dynamische Temperaturen und dynamisch thermische Prozesse zur Erzielung der gewünschten Schichteigenschaften verwendet.

Es werden erfindungsgemäß durch Steuern mindestens zwei einer absoluten Temperatur und/oder einer Temperaturveränderung aus einer Temperatur eines Einlasses T₁, von Kammerwänden T₂, von Hauptwaferträgern T₃, sich drehender einzelner Waferträger T₄, eines Gasauslasses T₅, eines Gasmischsystems T₆, der Oberseite einer Reaktionskammer T₇ und eines Heizsystems T₈ entsprechend auf numerischen Simulationen beruhenden mindestens im Sekundenbereich liegender (korrelierender) Tamperaturänderungsprofile zur unter Berücksichtigung der Änderung weiterer Prozessparameter im Reaktor (in Verbindung mit den Prozessgasen wie beispielsweise Austausch des Trägergases) erfolgenden Steuerung dynamisch thermischer Prozesse gezielt Materialeigenschaften erzeugt, die vorteilhaft auf Bauelemente, insbesondere auf elektronische und optoelektronische Bauelemente, wirken.

Erfindungsgemäß werden bevorzugt HF-(Hochfrequenz-) Heizungen durch das Temperaturverwaltungssystem angesteuert und zur Erzielung der Temperaturen und der Temperaturdynamik verwendet.

Durch die vorteilhaften Lösungsmerkmale des Hauptanspuchs können definierte Schichten, Grenzflächen und Schichtfolgen bzw. Heterostrukturen und Srukturen aus diesen Halbleiterkristallmaterialien mit justierbaren elektrischen und optische Eigenschaften wie Zusammensetzungen X,Y,Z,V,W der Verbindung von null bis 100%, spezifische elektrische Elektronenkonzentrationen bis 10²⁰ cm⁻³ und spezifische elektrische Löcherkonzentrationen bis 8x10¹⁸ cm⁻³ hergestellt werden.

Es können vorteilhaft A_{X}B_{Y}C_{Z}N_{V}M_{W}-Materialien und Schichtsysteme sowie dotierte Schichtsysteme hergestellt wurden.

Es kann vorteilhaft eine hohe Homogenität auch in einer lateralen Richtung erreicht werden.

Es kann vorteilhaft eine hohe Reproduzierbarkeit erreicht werden.

Es können vorteilhaft Bauelemente hergestellt werden. Dabei können das Bauelementeverhalten bzw. deren Eigenschaften wie beispielsweise Farbe und Leuchtkraft einer Leuchtdiode festgelegt werden. Beispielsweise können Feldemitter definiert hergestellt werden.

Ebenso können piezoelektrische Felder und Grenzflächenzustände festgelegt werden.

Es können vorteilhaft Quantentöpfe hergestellt werden.

Es können vorteilhaft n- und p- Dotierungen gleichzeitig ausgeführt werden.

Es kann vorteilhaft eine reproduzierbare Herstellung von A_{X}B_{Y}C_{Z},N_{V},M_{W-}Materialien mit unterschiedlichen Zusammensetzungen X, Y, Z, V, W und unterschiedlicher Reinheit ermöglicht werden.

Es kann vorteilhaft eine Herstellung von Grenzflächen zwischen A_{1X}B_{1Y}C_{1Z}N_{1V}M_{1W}/A_{2X}B_{2Y}C_{2Z}N_{2V}M_{2W}-Schichten mit unbeschränkt reproduzierbar justierbaren Übergangsprofilen ermöglicht werden.

Es kann vorteilhaft die Justierung der elektrischen Eigenschaften von Grenzflächen durch die Justierung des Temperaturprofils in der Reaktionskammer und des Temperatursteigungsschemas während der Herstellung zusammen mit einer passenden Schaltfolge der Gase ermöglicht werden. Die elektrischen Eigenschaften wie beispielsweise die Ladungsdichte, und die Störstellendichte, sowie die Struktur und die Zustandsdichte an den Grenzflächen werden zum Erreichen einer Justierung der Rekombinationsenergie in A_{1X}B_{1Y}C_{1Z}N_{1V}M_{1W}/A_{2X}B_{2Y}C_{2Z}N_{2V}M_{2W}-Heterostrukturen durch interne und externe elektrische Felder infolge der Bandverbiegung verwendet. Heterostrukturen mit Schichtdicken von einigen Mikrometern bis zu einem Bruchteil einer Monoschicht mit definierten optischen und elektrischen Eigenschaften können mittels eines Temperaturverwaltungssystem hergestellt werden.

Eine weitere vorteilhaft vorbestimmbare Eigenschaft ist die Oberflächenmorphologie der Halbleitermaterialien.

Weitere vorteilhaft vorbestimmbare Eigenschaften sind die Partikeldichte und die Störstellendichte auf der Waferoberfläche.

Ein weiterer Vorteil ist es, eine reproduzierbare und sehr gleichförmige bzw. einheitliche Aufbringung von A_{X}B_{Y}C_{Z},N_{V},M_{W}-Bestandteilen mit Bezug auf Dotierung, Schichtdicke, Zusammensetzung und allen weiteren für Anwendungen wichtigen Eigenschaften zu ermöglichen.

Durch das Steuern der Temperatur des Einlasses T₁ wird vorteilhaft die Art und Weise der Kondensation der Gase zur Beschichtung der Wafer justiert.

Durch das Steuern der Temperatur der Gefäßwände T₂ gemäß einer weiteren Ausführungsart wird vorteilhaft eine Temperaturdifferenz zwischen dieser Temperatur und der Temperatur des Hauptwaferträgers T₃ vermieden, so daß kein Energiefluß und keine Strömung zwischen diesen Reaktionskammerbauteilen erfolgen kann. Folglich ist ein gleichmäßiges Auskondensieren der Gase möglich. Steuertemperatur und Zieltemperatur ist hierbei die meßtechnisch nicht zugängliche Wafertemperatur der Wafer auf den Satelliten. Auch hier ändern sich alle Temperaturen dynamisch, da Reaktionskammerwände und Hauptwaferträger aus unterschiedlichen Materialien bestehen (Kohlenstoff und Metall) und im wesentlichen aufgrund der Wärmestrahlung. Die Kontrolle ist sehr schwierig.

Durch das Steuern der Temperatur des Hauptwaferträgers T₃ gemäß einer weiteren Ausführungsart wird das Temperaturprofil in der Reaktionskammer und das Temperatursteigungsschema während der Herstellung reproduzierbar festgelegt. Somit wird vorteilhaft die Justierung der elektrischen Eigenschaften von Grenzflächen durch die Justierung des Temperaturprofils in der Reaktionskammer und des Temperatursteigungsschemas während der Herstellung zusammen mit einer passenden Schaltfolge der Gase ermöglicht.

Durch das Steuern der Temperatur sich drehender einzelner Waferträger T₄ gemäß einer weiteren Ausführungsart werden alle Herstellungsbedingungen der einzelnen Waferträge an die des Hauptwäferträgers gekoppelt Somit werden vorteilhaft alle Wafer einheitlich hergestellt.

Durch das Steuern der Temperatur des Gasauslasses T₅ gemäß einer weiteren Ausführungsart werden vorteilhaft ein Temperaturgradient, und somit der Energiefluß und die Gasströmung zwischen den Waferträgern und dem Gasauslaß reproduzierbar festgelegt. Beim Steuern von T₅ (Gasauslaß) < T₄ (Waferträger) < T₃ (Hauptwaferträger) muß ebenfalls die Temperaturdynamik berücksichtigt werden, da nur der Waferträger aktiv geheizt wird und das Abkühlverhalten entsprechend berücksichtigt werden muß.

Durch das Steuern der Temperatur des Gasmischsystems T₆ gemäß einer weitern Ausführungsart werden vorteilhaft diese Temperatur und ein Temperaturgradient, und somit der Energiefluß und die Gasströmung zwischen dem Einlaß und dem Gasmischsystem reproduzierbar festgelegt.

Trotz der Temperaturdynamik von T₈ bzw. T₁ von beispielsweise 20-1400°C muss T₆ konstant gehalten werden.

Durch das Steuern der Temperatur der Oberseite der Reaktionskammer T₇ gemäß einer weiteren Ausführungsart werden gleichmäßig und reproduzierbar diese Temperatur, und ein Temperaturgradient, und somit der Energiefluß und die Gasströmung zwischen der Oberseite der Reaktionskammer und dem Hauptwaferträger festgelegt.

Durch das Steuern der Temperatur des Heizsystems T₈ gemäß einer weiteren Ausführungsart werden gleichmäßig und reproduzierbar diese Temperatur und folglich die Temperatur des Hauptwaferträgers T₃ festgelegt.

Bei den Steuerungen von T₇, T₈ und T₃ müssen ebenfalls die Dynamik und die Heizung/Kühlung berücksichtigt werden.

Durch zusätzliches Steuern der Parameter nach einem der weiteren Unteransprüche können vorteilhaft die Eigenschaften der Zusammensetzungen X, Y,Z,V,W, sowie die spezifische elektrische Elektronenkonzentration und die spezifische elektrische Löcherkonzentration reproduzierbar eingestellt werden. Der Gasstrom muß jedoch in Korrelation mit den dynamischen Temperaturänderungen gesteuert werden, da sich sonst die Bauelementeigenschaften ändern. Eine Änderung des Gasstroms hat ebenfalls eine Rückwirkung auf die Temperaturverteilung z. B. auf Wärmeleitfähigkeit und auf Kühlung.

Durch die weiter in den Unteransprüchen angegebenen Verfahrensschritte können weiterhin vorteilhaft vielfältige, A_{X}B_{Y}C_{Z}N_{V}M_{W}-Materialbestandteile enthaltende Produkte hergestellt werden, die beispielsweise durch Schichten, Grenzflächen, Schichtfolgen und Heterostrukturen mit entsprechenden Eigenschaften wie beispielsweise die Oberflächenmorphologie, Dotierung, Zusammensetzung, Reinheit, Störstellendichte bestimmt sind.

Durch die gemäß einer weiteren Ausführungsart angegebene temperaturgeregelte Injektion ist weiterhin vorteilhaft für eine Justierung der Homogenität, der Oberflächen- und der Schichteigenschaften vomehmbar.

### Kurzbeschreibung der Zeichnung

Die Erfindung wird nachstehend ohne Beschränkung des allgemeinen Erfindungsgedankens anhand von Ausführungsbeispielen unter Bezugnahme auf die Zeichnung exemplarisch beschrieben, auf die im übrigen hinsichtlich der Offenbarung aller im Text nicht näher erläuterten erfindungsgemäßen Einzelheiten ausdrücklich verwiesen wird. Es zeigen:
- Fig. 1: eine schematische Darstellung der Meßpunkte und der Rückführungsschleifen in der Reaktionskammer,
- Fig. 2: zeigt die Temperaturabhängigkeit der In-Aufnahrne von InGaN bezüglich der Temperatur T₃,
- Fig. 3: Temperaturprofile der Temperatur T₃ und T₇ für die Herstellung von GaN/InGaN-Heterostrukturen,
- Fig. 3a: ein Modell des Massentransports im Reaktor,
- Fig. 3b: eine mögliche Temperaturverteilung im Reaktor,
- Fig. 3c: ein Wärmemodell eines erfindungsgemäßen Temperatur- und Reaktionskammersytems,
- Fig. 4: die optischen Eigenschaften von mit dem erfindungsgemäßen Temperaturverwaltungssystem hergestellten InGaN/GaN-Quantentöpfen.
- Fig. 5: die mit dem erfindungsgemäßen System erreichte Gleichförmigkeit bzw. Einheitlichkeit der Zusammensetzung,
- Fig. 6: die mit dem erfindungsgemäßen System erreichte Gleichförmigkeit bzw. Einheitlichkeit der Dotierung,
- Fig. 7: die durch die Emissionswellenlänge angezeigte N-Aufnahme in Abhängigkeit von der Temperatur T₇ der Oberseite der Reaktionskammer, und
- Fig. 8: die Messung der Temperaturen T₁, T₂, T₇, T₈ und T₉ während einer Herstellungsverbarbeitung einer Heterostruktur.

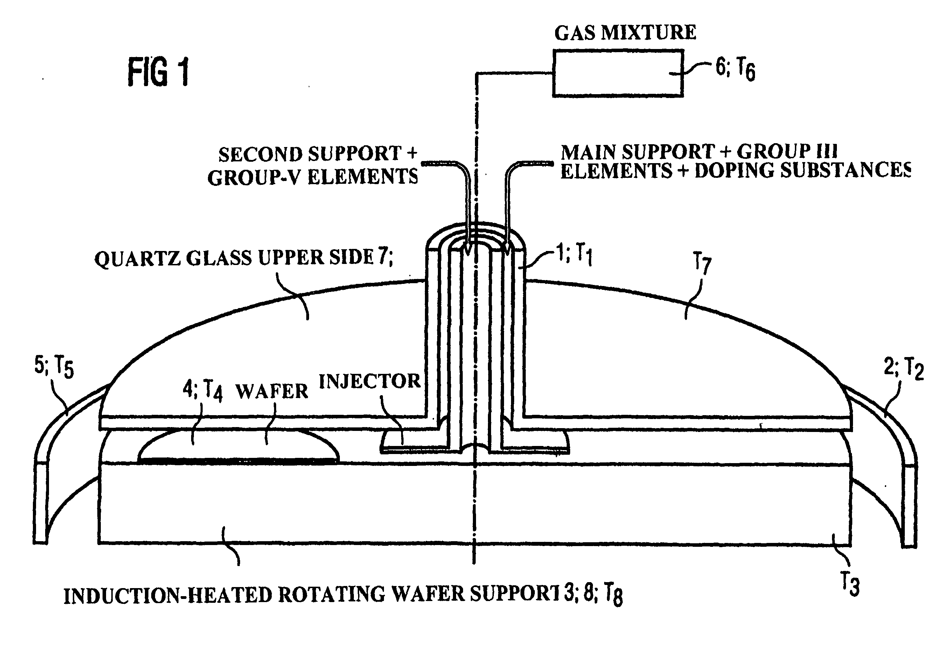

Zunächst soll der Aufbau des Reaktionskammersystems und die damit für das Temperaturverwaltungssystem wichtigen Temperaturmeßpunkte für folgende Temperaturen beschrieben werden. Fig. 1 zeigt diesen Aufbau. Das Bezugszeichen 1 bezeichnet einen Einlaß des Reaktionskammersystems mit der Temperatur T₁. Das Bezugszeichen 2 bezeichnet Reaktionskammerwände mit der Temperatur T₂. Das Bezugszeichen 3 bezeichnet einen Hauptwaferträger mit der Temperatur T_{3.} Das Bezugszeichen 4 bezeichnet sich drehende einzelne Waferträger mit der Temperatur T₄. Das Bezugszeichen 5 bezeichnet einen Gasauslaß mit der Temperatur T₅. Das Bezugszeichen 6 bezeichnet ein Gasmischsystem mit der Temperatur T₆. Das Bezugszeichen 7 bezeichnet die Oberseite eines Reaktionsgefäßes mit der Temperatur T₇. Das Bezugszeichen 8 bezeichnet ein Heizsystem mit der Temperatur T₈.

Die Reaktionskammer besteht aus einem horizontalen Träger für die Wafer. Die Reaktionsgase werden von oben eingeleitet, wobei sich eine horizontale Gasströmung ergibt. Es ist für das Verfahren eine Trennung zwischen den bestimmten Gasen zusammen mit einer Temperatursteuerung erforderlich. Gemäß dem Ausführungsbeispiel wird eine präzise Justierung und Steuerung der Temperaturen T₁ bis T₈ vorgenommen. Weitere Temperaturen können zur Optimierung des Herstellungsverfahrens als Parameter zusätzlich herangezogen werden.

Es ist möglich die im Einleitungsteil dieser Beschreibung angegebenen Eigenschaften anhand der Parameter zu optimieren.

Die Wärmeverwaltungssteuerung und die Rückführungssysteme bzw. Regelung beruhen auf Wärmeleitung und Wärmeströmung. Die Temperaturjustierung wird durch aktive Erwärmung, Wärmestrahlung und Kühlung unter Verwendung von Flüssigkeiten und Gasen erreicht. Das System ist durch mehrere regelmäßig überwachte Meßpunkte bestimmt, wobei die Meßwerte aufgezeichnet werden. Es erfolgt eine Justierung der Temperaturen, um die geforderten Temperatureinstellungen zu verwirklichen.

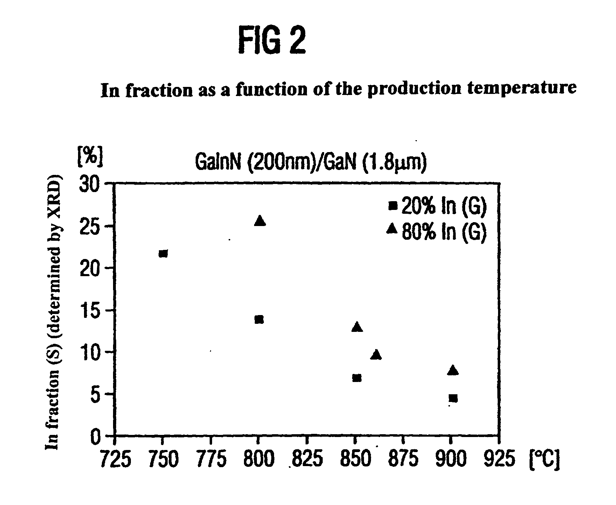

Fig. 2 zeigt die Abhängigkeit der In-Aufnahme von InGaN als Beispiel eines A_{X}B_{Y}C_{Z}N_{V}M_{W}-Materials in Abhängigkeit von der Temperatur des Hauptwaferträgers T₃.

Dabei zeigt sich in dem Temperaturbereich für T₃ von 725°C bis 925°C ein Absinken des In-Anteils im InGaN von ca. 25 % auf 5 %.

Fig. 3 veranschaulicht Temperaturprofile der Temperatur T₃ und T₇ für die Herstellung von GaN/InGaN-Heterostrukturen gemäß dem Ausführungsbeispiel.

Der erfindungsgemäße Prozeß für Halbleiter der Form A_{X}B_{Y}C_{Z}N_{V}M_{W} bedingt die Verwendung von unterschiedlichen Temperaturbereichen. Die Temperaturbereiche (siehe z. B. das Temperaturänderungsprofil gemäß Fig. 3) sind insbesondere

| | |
|---|---|
| 400-600°C | für die Nukleationsschicht zwischen Substrat und aktive Schichten |
| 200-800°C | für die optisch aktiven Schichten |
| 1000-1400°C | für elektrisch aktive Mantelschichten um die optisch aktive Schicht. |

Die Temperaturdynamik und nicht nur die absolute Stabilität bestimmt entscheidend das Bauelementverhalten wie z. B. die Farbe einer Leuchtdiode. Alle im Kapitel "Darstellung der Erfindung" genannten Eigenschaften sind davon betroffen.

Das Kriterium, daß Temperaturen unterhalb der Kondensationstemperatur eingestellt werden müssen, ist hier nicht anwendbar. Tatsächlich werden Depositionen an Teilen des Reaktors toleriert, um Temperatur- und Gasphasenzusammensetzungen zu erzielen, welche die gewünschten Bauelementeigenschaften erzielen. In der optisch aktiven Schicht (700-800°C) werden die Temperaturen z. B. derart eingestellt, daß eine nicht homogene Verteilung der Materialien im Halbleiter erzwungen wird. Die Steuerung sollte jedoch so erfolgen, daß eine Aduktbildung nicht erfolgt.

Diese erfindungsgemäße Temperaturverwaltung aller Temperaturen, die sich dynamisch ändern, führt zu völlig neuartigen Hersteliungsverfahren. Beispielsweise werden die Leuchtkraft und Farbe von Leuchtdioden und Lasern durch die so beeinflußten Eigenschaften der Potentialtöpfe, der Grenzfläche und des optisch aktiven Mediums bestimmt. Die Einflussnahmemöglichkeiten auf weitere Eigenschaften der erzeugten Produkte sind nicht begrenzt.

Die Temperaturregelung und die Erfassung der Genauigkeit sowie die Temperaturänderungsprofile - wie z.B. gemäß Fig. 3 - können nicht routinemäßig ermittelt werden, da die Positionen oft nicht zugänglich sind, z. B. Gasraum über dem Wafer. Die große Temperaturspanne von 400-1600°C erzwingt den Einsatz unterschiedlicher Meßsysteme mit oft nicht ausreichender Zeitauflösung bei Temperaturrampen. Weiterhin ändern einzelne Reaktorteile während des Prozesses ihre thermischen Eigenschaften z. B. das Abstrahlverhalten, so daß immer neue Temperaturen während jedem Prozeß ermittelt werden müssen. Zur Realisierung der Erfindung wurden umfangreiche numerische Simulationen der Temperaturverteilungen eingesetzt.

Die Fig. 3a bis 3c zeigen Bilder hinsichtlich der insbesondere zur Optimierung des Reaktors dienenden Simulationen. Diese sind Grundlage für optimierte Temperaturprofile.

Fig. 3a stellt ein Modell des Massentransports im Reaktor dar. Es werden der betrachtete Bereich und die Punkte beschrieben, an denen Berechnungen durchgeführt wurden (Gitter). Dies sowohl für den Massentransport als auch für das Temperaturverhalten.

Fig. 3b veranschaulicht die Temperaturverteilung im Reaktor. Es werden die Temperaturverteilung sowie die Annahme im Modell beschrieben. Ebenso sind der Messtechnik unzugängliche Stellen erfasst.

Fig. 3c zeigt ein Wärmemodell, das zusätzliche Einzelheiten angibt und sich auf nahezu alle Teile des erfindungsgemäßen Reaktors bzw. Temperatur- und Reaktionskammersystems bezieht.

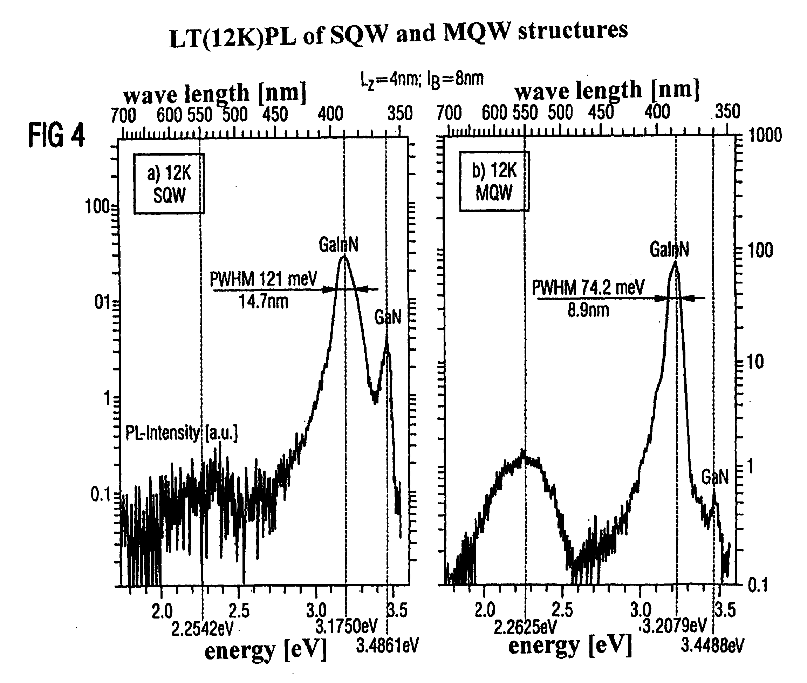

Fig. 4 veranschaulicht die optischen Eigenschaften von mit dem erfindungsgemäßen Temperaturverwaltungssystem hergestellten InGaN/GaN-Quantentöpfen.

Dabei zeigen sich beispielweise Werte für GalnN bei 3,17 eV für Einzelpotentialtöpf (SQW) und bei 3,20 eV für Mehrfachquantentöpfe (MQW).

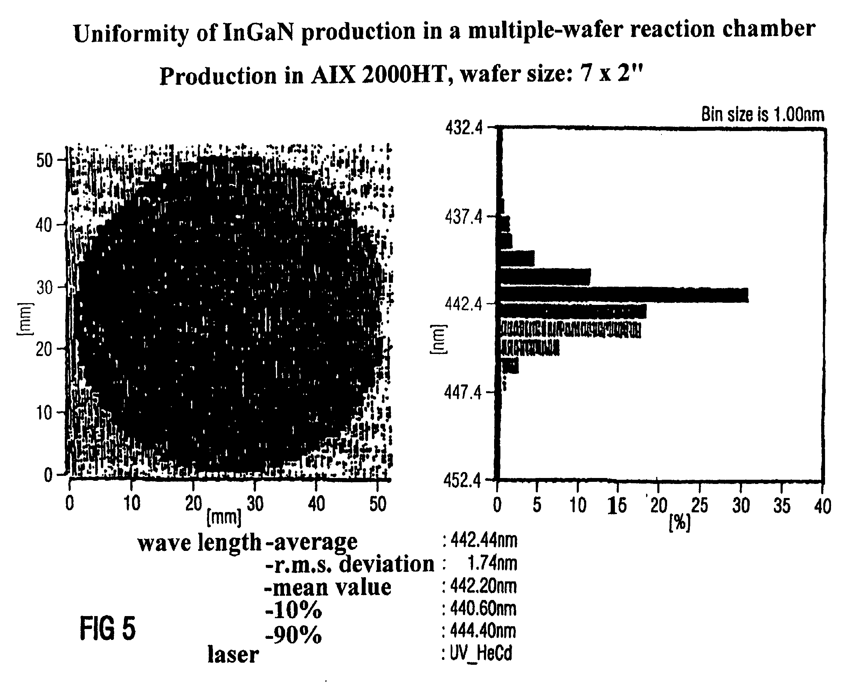

Fig. 5 stellt die mit dem erfindungsgemäßen System erreichte Gleichförmigkeit bzw. Einheitlichkeit der Zusammensetzung dar.

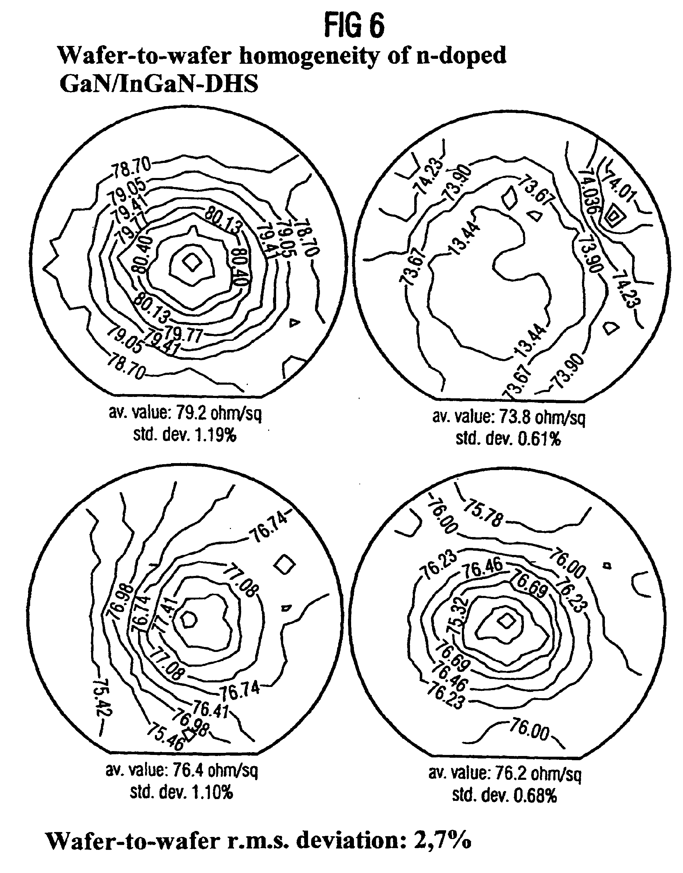

Fig. 6 veranschaulicht die mit dem erfindungsgemäßen System erreichte Gleichförmigkeit bzw. Einheitlichkeit der Dotierung.

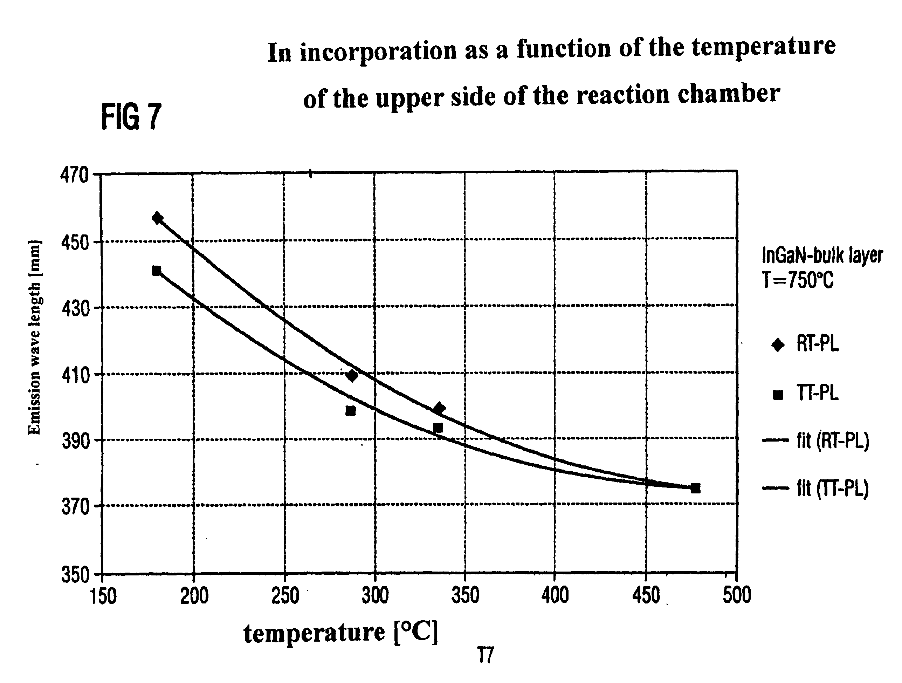

Fig. 7 zeigt die durch die Emissionswellenlänge angezeigte N-Aufnahme in Abhängigkeit von der Temperatur T₇ der Oberseite der Reaktionskammer.

Dabei verringert sich die N-Aufnahme mit steigender Temperatur der Oberseite der Reaktionskammer T_{7.}

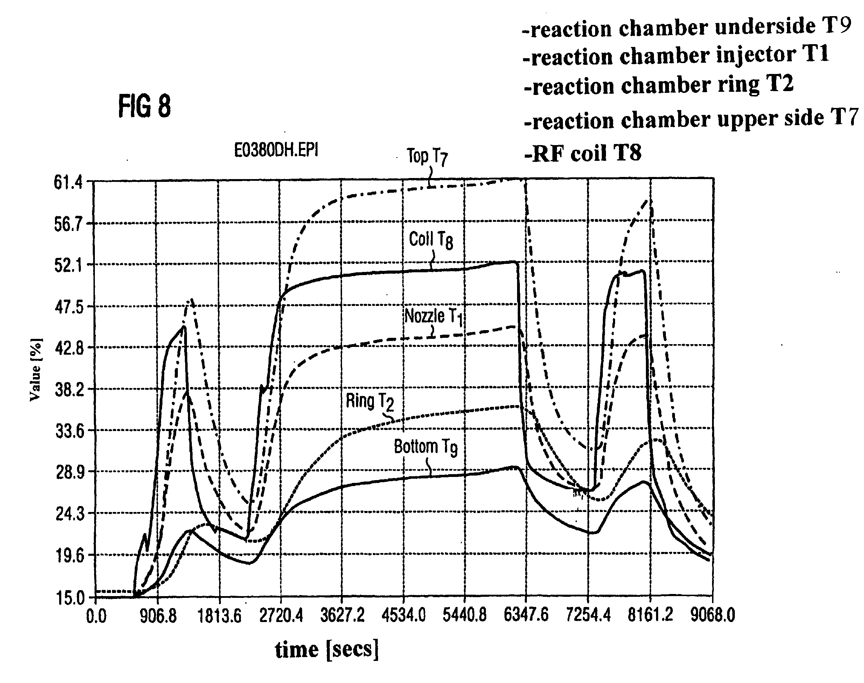

Fig. 8 stellt einen gemessenen Verlauf der Temperaturen T₁, T₂, T₇, T₈ und T₉ während einer Herstellungsverarbeitung einer Heterostruktur in Prozent dar.

Dabei ergeben sich gemäß dem Ausfühungsbeispiel die im Verfahrensablauf der Herstellung angegebenen Temperaturprofile.

## Patentansprüche

1. Verfahren zur Herstellung von Stickstoff enthaltenden Halbleiterkristallmaterialien der Form Aₓ B_{y} C_{z} Nᵥ M_{w},
wobei A, B, C halbleiterkristallbildende Gruppe-II- oder III- Elemente, N Stickstoff, M ein halbleiterkristallbildendes Gruppe-V- oder VI-Element und X,Y,Z,V,W der Molenbruch jedes Elements in dieser Verbindung darstellen,
unter Verwendung von Gasphasenzusammensetzungen und Gasphasenfolgen,
wobei in einer Reaktionskammer eines Reaktors auf einem Waferträger liegenden Substrat nacheinander mehrere Schichten aus dem besagten Halbleitermaterial abgeschieden werden,
wobei Schichten unterschiedlicher Materialeigenschaften bei unterschiedlichen Wachstumstemperaturen und unterschiedlicher Gaszusammensetzung erzeugt werden,
wobei zur dynamischen Änderung der Wachstumstemperatur zwischen dem Wachstum dieser Schichten die Wärmezufuhr von einer Heizung zum Waferträger von einer Steuereinrichtung geändert wird,
wobei von einem Temperaturverwaltungssystem die absoluten Temperaturen eines Einlasses (T₁), von Kammerwänden (T₂), von Hauptwaferträgern (T₃), sich drehender einzelner Waferträger (T₄), eines Gasauslasses (T₅), eines Gasmischsystems (T₆), der Oberseite einer Reaktionskammer (T₇) und eines Heizsystems (T₈) optimiert mindestens im Sekundenbereich geändert werden,
um unter Berücksichtigung der Änderung weiterer Prozessparameter im Reaktor gezielt Materialeigenschaften zu erzeugen,
wobei zusätzlich zu mindestens zwei der vorgenannten absoluten Temperaturen
auch die zeitliche Änderung mindestens einer dieser Temperaturen von dem Temperaturverwaltungssystem gesteuert wird,
wobei das Temperaturverwaltungssystem auf einer numerischen Simulation beruhende, zuvor ermittelte Temperaturänderungsprofile verwendet,
um unter
Berücksichtung der zeitlichen Änderung weiterer Prozessparameter im Reaktor erfolgenden Steuerung dynamisch thermischer Prozesse Heizungen anzusteuern und
wobei die Temperatur des Gasauslaß (T₅) kleiner als die Temperatur des Waferträgers (T₄) kleiner als die Temperatur des Hauptwaferträgers (T₃) gesteuert werden und dabei das Abkühlverhalten entsprechend berücksichtigt wird,
und die Temperaturjustierung durch die aktive Erwärmung, Wärmestrahlung und Kühlung unter Verwendung von Flüssigkeiten und Gasen erreicht wird.

2. Verfahren nach Anspruch 1, **gekennzeichnet durch** Steuern der Temperatur der Kammerwände (T₂) als gleich mit der Temperatur des Hauptwaferträgers (T₃).

3. Verfahren nach einem der Ansprüche 1 bis 2, **gekennzeichnet durch** Steuern der Temperatur des Hauptwafers (T₃) als konstant und bis zu 1600°C, bei benötigten reproduzierbaren Temperaturveränderungen von bis zu 250°C pro Minute.

4. Verfahren nach einem der Ansprüche 1 bis 3 **gekennzeichnet durch** auf 0,1°C genaues Steuern der Temperatur der einzelnen Waferträger (T₄) korrelierend mit der Temperatur des Hauptwaferträgers (T₃).

5. Verfahren nach einem der Ansprüche 1 bis 4 **gekennzeichnet durch** Steuern der Temperatur des Gamischsystems (T₆) als konstant und kleiner als der Temperatur des Einlasses (T₁).

6. Verfahren nach einem der Ansprüche 1 bis 5 **gekennzeichnet durch** Steuern der Temperatur der Oberseite der Reaktionskammer (T₇) als konstant und als korrelierend mit der Temperatur des Hauptwaferträgers (T₃).

7. Verfahren nach einem der Ansprüche 1 bis 6, **gekennzeichnet durch** Steuern der Temperatur des Heizsystems (T₈) als konstant und korrelierend mit der Temperatur des Hauptwaferträgers (T₃).

8. Verfahren nach einem der Ansprüche 1 bis 7, **gekennzeichnet durch** zusätzliches Steuern einer temperaturabhängigen Gasströmungsveränderung.

9. Verfahren nach einem der Ansprüche 1 bis 8, **gekennzeichnet durch** zusätzliches Steuern temperaturabhängiger Herstellungsunterbrechungen.

## Claims

1. Process for producing nitrogen-containing semiconductor crystal materials of the form Aₓ B_{y} C_{z} Nᵥ M_{w},
where A, B, C represent group II or III elements which form semiconductor crystals, N represents nitrogen, M represents a group V or group VI element which forms semiconductor crystals, and X, Y, Z, V, W represent the mole fraction of each element in this compound,
using vapour phase compositions and vapour phase sequences,
a plurality of layers of the said semiconductor material being deposited in a reaction chamber of a reactor on a substrate resting on a wafer support,
layers with different materials properties being produced at different growth temperatures and with different gas composition,
the supply of heat from a heater to the wafer support being altered by a control device in order to dynamically alter the growth temperature between the growth of these layers,
the absolute temperatures of an inlet (T₁), of chamber walls (T₂), of main wafer supports (T₃), of rotating individual wafer supports (T₄), of a gas outlet (T₅), of a gas mixing system (T₆), of the upper side of a reaction chamber (T₇) and of a heating system (T₈) being altered in optimized fashion at least in the seconds range by a temperature management system,
in order to produce materials properties in a targeted fashion, taking into account the alteration in further process parameters in the reactor,
the temporal change in at least one of these temperatures being controlled by the temperature management system in addition to at least two of the abovementioned absolute temperatures,
the temperature management system using predetermined temperature change profiles based on a numeric simulation in order to actuate heaters taking into account the temporal change in further process parameters controlling dynamically thermal processes in the reactor, and
the temperature of the gas outlet (T₅) being controlled to be lower than the temperature of the wafer support (T₄) which is for its part controlled to be lower than the temperature of the main wafer support (T₃), the cooling properties being thereby suitably taken into account,
and the temperature adjustment being achieved by the active heating, thermal radiation and cooling using liquids and gases.

2. Process according to Claim 1, **characterized by** controlling the temperature of the chamber walls (T₂) to be equal to the temperature of the main wafer support (T₃).

3. Process according to either of Claims 1 and 2, **characterized by** controlling the temperature of the main wafer (T₃) to be constant and up to 1600°C in the event of required reproducible temperature changes of up to 250°C per minute.

4. Process according to one of Claims 1 to 3, **characterized by** controlling the temperature of the individual wafer supports (T₄) to correlate to the temperature of the main wafer support (T₃) to within an accuracy of 0.1°C.

5. Process according to one of Claims 1 to 4, **characterized by** controlling the temperature of the gas mixing system (T₆) to be constant and lower than the temperature of the inlet (T₁).

6. Process according to one of Claims 1 to 5, **characterized by** controlling the temperature of the upper side of the reaction chamber (T₇) to be constant and correlated with the temperature of the main wafer support (T₃).

7. Process according to one of Claims 1 to 6, **characterized by** controlling the temperature of the heating system (T₈) to be constant and correlated with the temperature of the main wafer support (T₃).

8. Process according to one of Claims 1 to 7, **characterized by** additional control of a temperature-dependent gas flow change.

9. Process according to one of Claims 1 to 8, **characterized by** additional control of temperature-dependent production interruptions.

## Revendications

1. Procédé de fabrication de matériaux cristallins semi-conducteursde la forme AₓB_{y}C_{z}NᵥM_{w} contenant de l'azote,
A, B, C représentant des éléments du groupe II ou III formant un cristal semi-conducteur, N étant l'azote, M représentant un élément du groupe V ou VI formant un cristal semi-conducteur et x, y, z, v, w représentant la fraction molaire de chaque élément dans ce composé, en utilisant des composés en phase gazeuse et des cycles en phase gazeuse,
plusieurs couches dudit matériau semi-conducteur étant déposées successivement sur un substrat disposé sur un support de plaquette dans une chambre de réaction d'un réacteur,
des couches présentant différentes propriétés de matériau étant générées à différentes températures de croissance et différentes compositions de gaz,
l'apport de chaleur d'un dispositif de chauffage au support de plaquette étant modifié au moyen d'un dispositif de commande afin de faire varier dynamiquement la température de croissance des couches entre la croissance de ces couches,
les températures absolues d'une entrée (T₁), des parois de la chambre (T₂), des supports de plaquette principaux (T₃), de supports de plaquette individuels rotatifs (T₄), d'une sortie de gaz (T₅), d'un système de mélange de gaz (T₆), du côté supérieur d'une chambre de réaction (T₇) et d'un système de chauffage (T₈) étant modifiées de façon optimisée au moins à l'échelle de la seconde par un système de gestion de température, afin d'obtenir de façon ciblée des propriétés de matériau en tenant compte de la variation d'autres paramètres de procédé dans le réacteur,
la variation dans le temps d'au moins une de ces températures étant également commandée par le système de gestion de température en plus d'au moins deux températures absolues susmentionnées,
le système de gestion de température utilisant des profils de variation de température prédéterminés et reposant sur une simulation numérique afin de piloter des dispositifs de chauffage, permettant de commander dynamiquement des procédés thermiques, en tenant compte de la variation dans le temps d'autres paramètres de procédé dans le réacteur,
la température de la sortie de gaz (T₅) étant commandée pour être inférieure à la température du support de plaquette (T₄) qui est elle-même commandée pour être inférieure à la température du support de plaquette principal (T₃) et le comportement en refroidissement étant alors pris en compte de façon appropriée, et le réglage des températures étant réalisé par chauffage actif, rayonnement thermique et refroidissement en utilisant des liquides et des gaz.

2. Procédé selon la revendication 1, **caractérisé en ce que** la température des parois de chambre (T₂) est commandée pour être égale à la température de la plaquette de support principale (T₃).

3. Procédé selon l'une des revendications 1 à 2, **caractérisé en ce que** la température de la plaquette principale (T₃) est commandée pour être constante et ce jusqu'à 1600°C, avec des variations de température reproductibles nécessaires jusqu'à 250°C par minute.

4. Procédé selon l'une des revendications 1 à 3, **caractérisé en ce que** la température des supports de plaquette individuels (T₄) est commandée à 0,1 °C près en corrélation avec la température du support de plaquette principal (T₃).

5. Procédé selon l'une des revendications 1 à 4, **caractérisé en ce que** la température du système de mélange de gaz (T₆) est commandée pour être constante et inférieure à la température de l'entrée (T₁).

6. Procédé selon l'une des revendications 1 à 5, **caractérisé en ce que** la température du côté supérieur de la chambre de réaction (T₇) est commandée pour être constante et en corrélation avec la température du support de plaquette principal (T₃).

7. Procédé selon l'une des revendications 1 à 6, **caractérisé en ce que** la température du système de chauffage (T₈) est commandée pour être constante et en corrélation avec la température de la plaquette de support principale (T₃).

8. Procédé selon l'une des revendications 1 à 7, **caractérisé en ce que** l'on commande en plus une variation de l'écoulement de gaz en fonction de la température.

9. Procédé selon l'une des revendications 1 à 8, **caractérisé en ce que** l'on commande en plus des interruptions de fabrication en fonction de la température.
